# EUROPEAN PATENT SPECIFICATION

(11) **EP 2 187 262 B1**
(45) Date of publication and mention of the grant of the patent: **18.03.2015**
(21) Application number: 09252634.2
(22) Date of filing: 17.11.2009
(51) Int. Cl.: G03F 7/00, B29C 33/38, H05K 3/12

(54) **Microcontact printing stamp**
Mikrokontaktdruckstempel
Tampon pour l'impression par micro-contact

(30) Priority: 17.11.2008 JP 2008293001
(43) Date of publication of application: 19.05.2010
(73) Proprietor: Shin-Etsu Chemical Co., Ltd., Tokyo (JP)
(72) Inventor: Mogi, Hiroshi , Silicone-Electronics Materials, Annaka-shi, Gunma-ken (JP)
(74) Representative: Stoner, Gerard Patrick

(56) References cited:
- WO-A1-2005/105401
- US-A1- 2004 170 770
- US-A1- 2008 145 525
- CHOI W M ET AL: "A soft-imprint technique for direct fabrication of submicron scale patterns using a surface-modified PDMS mold" MICROELECTRONIC ENGINEERING, ELSEVIER PUBLISHERS BV., AMSTERDAM, NL, vol. 70, no. 1, 1 October 2003 (2003-10-01), pages 131-136, XP004458407 ISSN: 0167-9317
- YAN Y H ET AL: "CF4 plasma treatment of poly(dimethylsiloxane): Effect of fillers and its application to high-aspect-ratio UV embossing" LANGMUIR 20050913 AMERICAN CHEMICAL SOCIETY US, vol. 21, no. 19, 13 September 2005 (2005-09-13), pages 8905-8912, XP002568909
- SCHMID H ET AL: "Siloxane polymers for high-resolution, high-accuracy soft lithography" MACROMOLECULES, ACS, WASHINGTON, DC, US, vol. 33, no. 8, 25 March 2000 (2000-03-25) , pages 3042-3049, XP002385970 ISSN: 0024-9297
- ROTHROCK G D ET AL: "High-performance imprint lithography and novel metrology methods using multifunctional perfluoropolyethers" PROCEEDINGS OF THE SPIE - THE INTERNATIONAL SOCIETY FOR OPTICAL ENGINEERING, SPIE, US, vol. a, 1 March 2006 (2006-03-01), pages 61523F-1, XP002459516 ISSN: 0277-786X

## Description

This invention relates to silicone rubber stamps for microcontact printing, and more particularly, to silicone rubber stamps for microcontact printing which have been cured in elastomeric form, facilitate transfer of electroconductive ink or semiconductor ink to form a pattern of fine features and are unsusceptible to swelling with ink solvents.

As commonly used in the microcontact printing technology, the term "stamp" used herein refers to a silicone rubber material with the desired fine feature pattern which is obtained by casting a silicone rubber composition in an uncured state on a master with the negative of the desired fine feature pattern, curing the composition, and removing the cured composition from the master.

### BACKGROUND

Silicone rubber is widely used in a variety of fields owing to its heat resistance, freeze resistance and electrical properties. In particular, the silicone rubber is regarded promising as the microcontact printing stamp material because it is fully flowable and allows for dimensional reproducible reversal from a master with the negative of the desired micro-feature pattern. Among others, liquid silicone rubber compositions of the addition reaction cure type are often used from the standpoints of dimensional reproducibility and ease of working.

Such silicone rubber compositions are generally supplied as comprising an organopolysiloxane having a high degree of polymerization and a reinforcing resin. These compositions are prepared by admixing a starting polymer with reinforcing resin and various dispersants in a mixing apparatus such as a universal mixer or kneader. Since the organopolysiloxane and reinforcing resin generally contain methyl groups as pendants from the siloxane skeleton, the silicone rubber composition obtained by admixing them and the cured product or silicone rubber are susceptible to swelling with solvents in ink materials used in microcontact printing. When used as the microcontact printing stamp for fine pattern printing, they are unable to transfer patterns of the desired size.

One prior art means for controlling solvent swell of silicone rubber is use of fluorosilicone as disclosed in USP 6,369,155 (JP-A 2001-002923). Since the fluorosilicone is not effective in hydrocarbon solvents, a problem of dimensional accuracy is left unsolved. Stamps made solely of fluororubber are very weak in strength and cannot be used alone in microcontact printing.

US Published Patent Application 20080145525 describes a silicon or polymer stamp covered with a thin layer of a cured perfluoropolyether diacrylate.

### Citation List

Patent Document 1: USP 6,369,155 (JP-A 2001-002923)
Patent Document 2: US 2008/0145525

An object of the invention is to provide a microcontact printing stamp which is capable of pattern transfer at high dimensional accuracy by combining sufficient strength with low susceptibility to swelling.

The inventor has found that a microcontact printing stamp can be produced by covering a surface of an addition reaction cure silicone rubber composition in the cured state with a fluoroelastomer composition in the cured state to form a laminate structure, and that the resulting stamp has sufficient strength, is unsusceptible to swelling with ink solvents, and is capable of pattern transfer at a high dimensional accuracy

Accordingly, the invention provides a microcontact printing stamp comprising, in laminate structure, a cured layer of an addition reaction cure silicone rubber composition overlaid with a cured layer of a fluoroelastomer composition according to claim 1.

In a preferred embodiment, the addition reaction cure silicone rubber composition comprises (A) an organopolysiloxane containing at least two aliphatic unsaturated monovalent hydrocarbon groups in a molecule, (B) an organohydrogenpolysiloxane containing at least two silicon-bonded hydrogen atoms in a molecule, (C) an addition reaction catalyst, and (D) a reinforcing resin. More preferably, the addition reaction cure silicone rubber composition comprises 100 parts by weight of component (A), component (B) in a sufficient amount to give 0.5 to 5 silicon-bonded hydrogen atoms per aliphatic unsaturated monovalent hydrocarbon group in components (A) and (D), component (C) in a sufficient amount to give 1 to 100 ppm of platinum atom based on the weight of component (A), and 5 to 100 parts by weight of component (D). In a preferred embodiment, component (A) is a linear diorganopolysiloxane, and component (D) is a reinforcing resin containing alkenyl groups.

The fluoroelastomer composition comprises a polyether compound having a fluorinated polyether skeleton. The fluoroelastomer composition further comprises a compound having a reactive group for silicone crosslinking. The fluoroelastomer composition is a curable perfluoropolyether composition comprising (E) a linear perfluoropolyether compound containing at least two aliphatic unsaturated monovalent hydrocarbon groups in a molecule, having a perfluoropolyether structure containing recurring units: -CₐF₂ₐO- wherein a is an integer of 1 to 6 in the backbone, and having a number average molecular weight of 5,000 to 100,000, and (F) a compound having at least two silicon-bonded hydrogen atoms in a molecule. More preferably, the perfluoropolyether composition comprises 100 parts by weight of component (E) and 1 to 10 parts by weight of component (F).

Methods of manufacture and use are further aspects.

### ADVANTAGEOUS EFFECTS

The microcontact printing stamp has a high strength and is unsusceptible to swelling with solvents used in ink solutions.

### FURTHER EXPLANATIONS; OPTIONS AND PREFERENCES

As used herein, the term "ppm" refers to parts by weight per million parts by weight.

The microcontact printing stamp of the invention comprises, in laminate structure, a cured layer of an addition reaction cure silicone rubber composition overlaid with a cured layer of a fluoroelastomer composition.

### Silicone rubber composition

In a preferred embodiment, the addition reaction cure silicone rubber composition comprises the following components (A) to (D). The components are:
(A) an organopolysiloxane containing at least two aliphatic unsaturated monovalent hydrocarbon groups in a molecule,
(B) an organohydrogenpolysiloxane containing at least two silicon-bonded hydrogen atoms (i.e., SiH groups) in a molecule,
(C) an addition reaction catalyst, and preferably
(D) a reinforcing resin.

Component (A) serving as a base polymer in the stamp material is an organopolysiloxane containing at least two, preferably at least three silicon-bonded aliphatic unsaturated monovalent hydrocarbon groups in a molecule. Any organopolysiloxane capable of forming a network structure through addition reaction may be used.

Suitable aliphatic unsaturated monovalent hydrocarbon groups include alkenyl groups of 2 to 6 carbon atoms such as vinyl, allyl, propenyl, 1-butenyl and 1-hexenyl. Inter alia, vinyl is most preferred because of ease of synthesis, fluidity of an uncured composition, and heat resistance of a cured composition.

The organopolysiloxane may contain other silicon-bonded organic groups. Suitable organic groups are substituted or unsubstituted monovalent hydrocarbon groups of 1 to 10 carbon atoms, excluding the aliphatic unsaturated monovalent hydrocarbon groups, for example, alkyl groups such as methyl, ethyl, propyl, butyl, pentyl, hexyl, octyl, decyl and dodecyl, aryl groups such as phenyl, aralkyl groups such as benzyl, 2-phenylethyl and 2-phenylpropyl, and substituted hydrocarbon groups, typically halo- or cyano-substituted groups, such as chloromethyl, chlorophenyl, 2-cyanoethyl, and 3,3,3-trifluoropropyl. Inter alia, methyl is most preferred because of ease of synthesis and a good balance of properties including mechanical strength and uncured fluidity.

The aliphatic unsaturated monovalent hydrocarbon groups may be present at the end(s) or intermediate positions(s) of the organopolysiloxane molecular chain or both. The organopolysiloxane (A) which is preferred for providing the cured composition with improved mechanical properties is a linear diorganopolysiloxane in which the backbone consists of recurring diorganosiloxane units and is capped at both ends with triorganosiloxy groups, and at least aliphatic unsaturated monovalent hydrocarbon groups (like alkenyl groups) at both ends are included.

The siloxane skeleton may have a linear, branched or three-dimensional network structure. A blend of a linear diorganopolysiloxane and a branched organopolysiloxane is preferred in order that the cured composition have good mechanical properties suitable for use as microcontact printing stamps. However, when a silicone rubber mold is used in the casting of an epoxy resin and specifically a transparent epoxy resin requiring surface smoothness, the presence of a branched organopolysiloxane is undesirable in that a silicone rubber mold may be increased in hardness or compromised in smoothness as a result of resinification of the branched organopolysiloxane. Where a blend as mentioned above is used as the organopolysiloxane (A), preferably the blend consists of 2 to 40% by weight of a branched and/or three-dimensional network organopolysiloxane consisting of R₃SiO_{1/2} units, SiO₂ units and optionally R₂SiO_{2/2} units (wherein R represents an organic group and aliphatic unsaturated monovalent hydrocarbon group as mentioned above, with at least two, preferably at least three aliphatic unsaturated monovalent hydrocarbon groups being present per molecule) and the balance of a linear diorganopolysiloxane having a backbone consisting of recurring R₂SiO_{2/2} units and terminals consisting of R₃SiO_{1/2} units, more specifically having aliphatic unsaturated monovalent hydrocarbon groups at both ends of its molecular chain.

To distinguish(A) from (D) (described later): if (D) is organopolysiloxane containing alkenyl groups, component (A) should then be linear diorganopolysiloxane or at least not have 3-dimensional network structure to an extent specified for (D).

Component (A) should preferably have a viscosity of 500 to 500,000 mm²/s, and more preferably 1,000 to 100,000 mm²/s as measured at 25°C by an Ostwald viscometer, in order that the uncured composition have a satisfactory flow and ease of working and the cured composition have an adequate elasticity.

Component (B) is an organohydrogenpolysiloxane containing at least two silicon-bonded hydrogen atoms (i.e., hydrosilyl or SiH groups) in a molecule. Component (B) serves as a crosslinker for components (A) and any (D) in that the hydrosilyl groups undergo addition reaction to aliphatic unsaturated monovalent hydrocarbon groups in components (A) and any (D). In order that the cured product have network structure, the number of silicon-bonded hydrogen atoms participating in the addition reaction is at least 2 (specifically 2 to about 300), and preferably at least 3 (specifically 3 to about 200).

Organic groups attached to silicon atoms in the siloxane units are exemplified by the same as the organic groups other than the aliphatic unsaturated monovalent hydrocarbon groups described in conjunction with component (A). Inter alia, methyl is most preferred for ease of synthesis.

The organohydrogenpolysiloxane has a siloxane skeleton which may be linear, branched, cyclic or three-dimensional network. While a mixture of such structures may be used, a linear one is preferred.

For component (B), the degree of polymerization (or the number of silicon atoms per molecule) is not particularly limited. However, since an organohydrogenpolysiloxane having at least two hydrogen atoms bonded to a common silicon atom is difficult to synthesize, those organohydrogenpolysiloxanes including at least three siloxane units are preferred (for example, the number of silicon atoms per molecule is 3 to about 300, preferably 4 to about 200). The organohydrogenpolysiloxane should preferably have a viscosity of 15 to 200 mm²/s as measured at 25°C by an Ostwald viscometer, for ease of handling and no volatilization during shelf storage and during heating for cure reaction.

Component (B) is compounded in such amounts to provide 0.5 to 5, preferably 1 to 3 silicon-bonded hydrogen atoms per aliphatic unsaturated monovalent hydrocarbon group in components (A) and any (D). Smaller amounts to provide a hydrogen atom/unsaturated group ratio of less than 0.5 are undesired in that the cure reaction is not completed so that a cured product of the composition becomes tacky and hence, poor in parting property when a microcontact printing stamp is formed on a master having the negative of the desired fine pattern. Inversely, larger amounts to provide a hydrogen atom/unsaturated group ratio of more than 5 may lead to an increased occasion of foaming upon curing. Such foams may accumulate at the interface when a microcontact printing stamp is formed on a master having the negative of the desired fine pattern, inhibiting reversal of the desired fine pattern.

Component (C) is an addition reaction catalyst which is typically selected from platinum compounds. Platinum compounds serve as a catalyst for promoting addition reaction between aliphatic unsaturated monovalent hydrocarbon groups in components (A) and (D) and hydrosilyl groups in component (B) and exhibit catalysis for curing reaction around room temperature.

Examples of suitable platinum compounds include chloroplatinic acid, complexes obtained through reaction of chloroplatinic acid with alcohols, platinum-olefin complexes, platinum-vinylsiloxane complexes, platinum-ketone complexes, and platinum-aldehyde complexes. Of these, the reaction products of chloroplatinic acid with alcohols and platinum-vinylsiloxane complexes are preferred for solubility in components (A) and (B) and catalytic activity.

Component (C) is compounded in such amounts as to provide 1 to 100 ppm, and preferably 2 to 50 ppm of platinum atom based on the weight of component (A). Less than 1 ppm of platinum may provide a low cure speed, at which the cure reaction may not be completed so that a silicone rubber product may become tacky and hence, poor in parting property when it is parted from a master, and poor in parting property when replicas are parted from it. More than 100 ppm of platinum may lead to an extremely high cure speed that may hinder working after the components are combined together, and be uneconomical.

Component (D) is a reinforcing resin for endowing the cured composition with mechanical properties (typically strength). Preferred are organopolysiloxane resins of three-dimensional network structure containing siloxane units of R¹₃SiO_{1/2} and siloxane units of SiO_{4/2} and optionally containing alkenyl groups, wherein R¹ is independently a substituted or unsubstituted monovalent hydrocarbon group.

Suitable substituted or unsubstituted monovalent hydrocarbon groups represented by R¹ are exemplified by the same as the aliphatic unsaturated monovalent hydrocarbon groups and the organic groups other than the aliphatic unsaturated monovalent hydrocarbon groups described in conjunction with component (A).

It is preferred for mechanical properties of the cured composition that R¹₃SiO_{1/2} units and SiO_{4/2} units be contained such that a molar ratio of R¹₃SiO_{1/2/}SiO₂ is from 0.3 to 2, and more preferably from 0.7 to 1. If necessary, the reinforcing resin may further contain R¹₂SiO units and R¹SiO_{3/2} units each in a proportion of 0 to 10 mol%, and preferably 0 to 5 mol% of the reinforcing resin wherein R¹ is as defined above.

Component (D) is preferably compounded in an amount of 5 to 100 parts, and more preferably 10 to 60 parts by weight per 100 parts by weight of component (A), because the microcontact printing stamp obtained by curing of such a composition usually has good mechanical properties (typically strength).

In addition to components (A) to (D), the silicone rubber composition of the addition reaction cure type of the invention may have any other components compounded therein for a particular purpose as long as the objects of the invention are not compromised. For example, cure retarders such as acetylene compounds, diallyl maleate, triallyl isocyanurate, nitrile compounds and organic peroxides may be compounded for prolonging the cure time of the silicone rubber composition at room temperature for facilitating working. Additionally, parting agents, pigments, plasticizers, flame retardants, thixotropic agents, fungicidal agents, mildew-proof agents or the like may be compounded, if desired.

The silicone rubber composition may be prepared by intimately mixing components (A) to (D) and optional components on a mixing apparatus such as a planetary mixer, Shinagawa mixer, universal mixer or kneader. Most often, the composition is prepared in a two pack system, one pack including component (B) and the other pack including component (C), which are separately stored and intimately mixed together immediately before use. Alternatively, all the components may be stored in a common container in the presence of a cure retarder.

According to the invention, a cured product of the addition reaction cure silicone rubber composition on its surface is overlaid with a cured product of a fluoroelastomer composition to form an integral laminate structure, which serves as a microcontact printing stamp.

### Fluoroelastomer composition

The fluoroelastomer composition comprises a polyether compound having a fluorinated polyether skeleton and a compound having a reactive group for silicone crosslinking. The fluoroelastomer composition is a curable perfluoropolyether composition comprising (E) a linear perfluoropolyether compound containing at least two aliphatic unsaturated monovalent hydrocarbon groups in a molecule, having a perfluoropolyether structure containing recurring units: -CₐF₂ₐO- wherein a is an integer of 1 to 6 in the backbone, and having a number average molecular weight of 5,000 to 100,000, and (F) a compound having at least two silicon-bonded hydrogen atoms (i.e., SiH groups) in a molecule.

The curable perfluoropolyether composition from which the cured fluoroelastomer is produced is described in further detail. The curable perfluoropolyether composition used herein preferably comprises components (E) to (G):
(E) a linear perfluoropolyether compound containing at least two aliphatic unsaturated monovalent hydrocarbon groups in a molecule, having a perfluoropolyether structure containing recurring units: -CₐF₂ₐO- wherein a is an integer of 1 to 6 in the backbone, and having a number average molecular weight of 5,000 to 100,000,
(F) a compound having at least two silicon-bonded hydrogen atoms (i.e., SiH groups) in a molecule, and
(G) an addition reaction catalyst.

Component (E) is a linear perfluoropolyether compound containing at least 2, preferably 2 to 6, aliphatic unsaturated monovalent hydrocarbon groups in a molecule, having a perfluoropolyether structure, preferably a divalent perfluoroalkylether structure in the backbone, and having a number average molecular weight of 5,000 to 100,000.

Examples of the divalent perfluoroalkylether structure include structures containing a multiplicity of recurring units: -CₐF₂ₐO- wherein a is independently an integer of 1 to 6, for example, a structure of the following formula (1):

(CₐF₂ₐO)_{q} (1)

wherein a is as defined above, and q is an integer of 20 to 600, preferably 20 to 400, and more preferably 20 to 200.

Examples of recurring units: -CₐF₂ₐO- in formula (1) include the following:

-CF₂O-,

-CF₂CF₂O-,

-CF₂CF₂CF₂O-,

-CF(CF₃)CF₂O-,

-CF₂CF₂CF₂CF₂O-,

-CF₂CF₂CF₂CF₂CF₂CF₂O-,

and

-C(CF₃)₂O-.

Of these, -CF₂O-, -CF₂CF₂O-, -CF₂CF₂CF₂O-, and -CF(CF₃)CF₂O-units are preferred. Note that the perfluoroalkylether structure may consist of either recurring units of one type or recurring units of more than one type.

In the linear perfluoropolyether compound (E), the aliphatic unsaturated monovalent hydrocarbon groups are preferably alkenyl groups, specifically of 2 to 8 carbon atoms, more specifically 2 to 6 carbon atoms, and terminated with a CH₂=CH- structure. Typical are groups terminated with a CH₂=CH- structure such as vinyl, allyl, propenyl, isopropenyl, butenyl and hexenyl, with the vinyl and allyl groups being more preferred.

In addition to the aliphatic unsaturated monovalent hydrocarbon groups, the perfluoropolyether compound may contain other organic groups. Suitable organic groups are substituted or unsubstituted monovalent hydrocarbon groups of 1 to 10 carbon atoms, excluding the aliphatic unsaturated monovalent hydrocarbon groups, for example, alkyl groups such as methyl, ethyl, propyl, butyl, pentyl, hexyl, octyl, decyl and dodecyl, aryl groups such as phenyl, aralkyl groups such as benzyl, 2-phenylethyl and 2-phenylpropyl, and substituted hydrocarbon groups, typically halo- or cyano-substituted groups, such as chloromethyl, chlorophenyl, 2-cyanoethyl, and 3,3,3-trifluoropropyl. Inter alia, methyl is most preferred because of ease of synthesis and a good balance of properties including mechanical strength and uncured fluidity.

The linear perfluoropolyether compound has a number average molecular weight Mn of 5,000 to 100,000, preferably 5,000 to 30,000, as measured by gel permeation chromatography (GPC) versus polystyrene standards. With Mn < 5,000, rubber physical properties (e.g., tensile strength, elongation) may be insufficient. With Mn > 100,000, there are available too fewer crosslinking reaction sites for cure reaction to take place.

Examples of the linear perfluoropolyether compound (E) are given below. 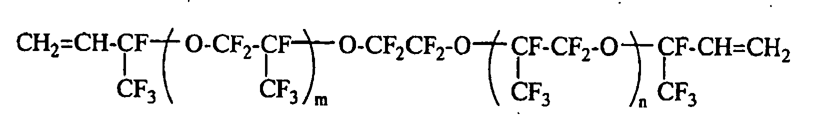 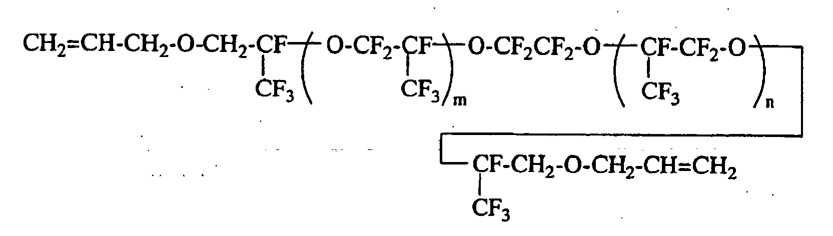 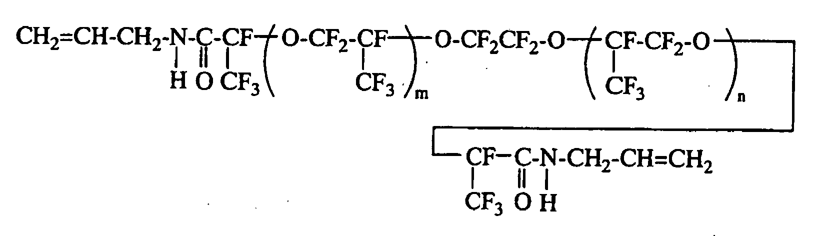 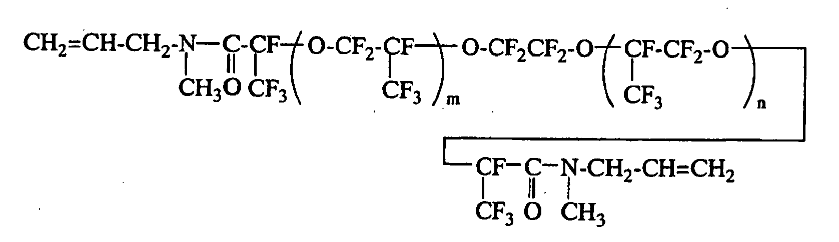 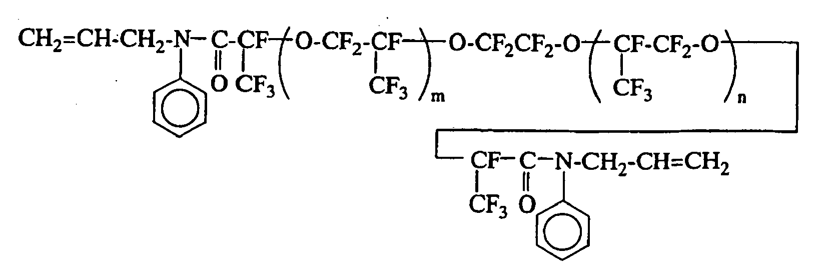 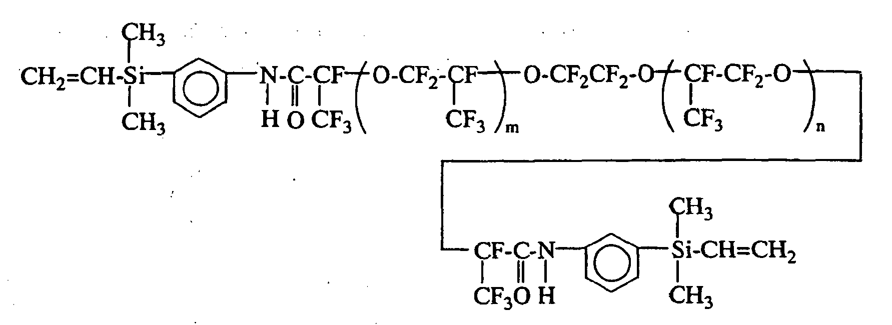 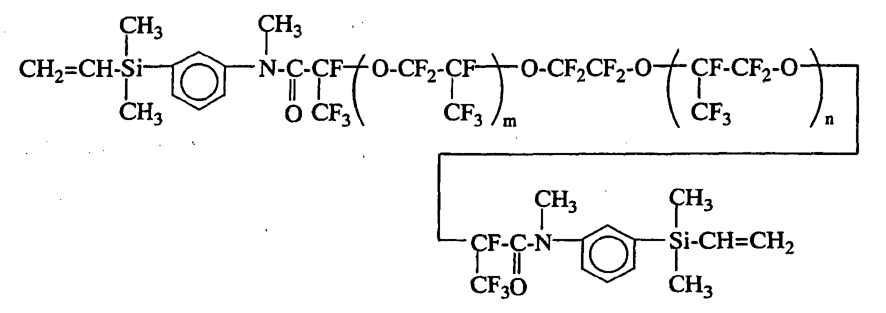 Herein, m and n are integers not equal to 0 at the same time, and typically such integers of at least 1 that the compound of each formula has a Mn of 5,000 to 100,000.

The linear perfluoropolyether compounds may be used alone or in admixture of two or more.

Component (F) is a compound having at least two silicon-bonded hydrogen atoms (i.e., SiH groups) in a molecule. Preferred are organosilicon compounds having at least 1, preferably 1 or 2, perfluoroalkyl or perfluoropolyether substituent group, and at least 2, preferably 3 to 6, silicon-bonded hydrogen atoms (i.e., SiH groups) in a molecule.

Examples of the compound (F) are given below. Note that Me is methyl and Ph is phenyl.

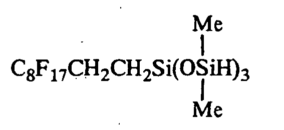

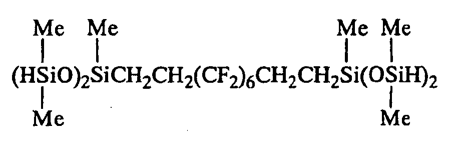

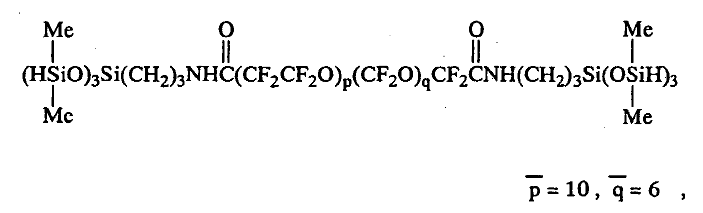

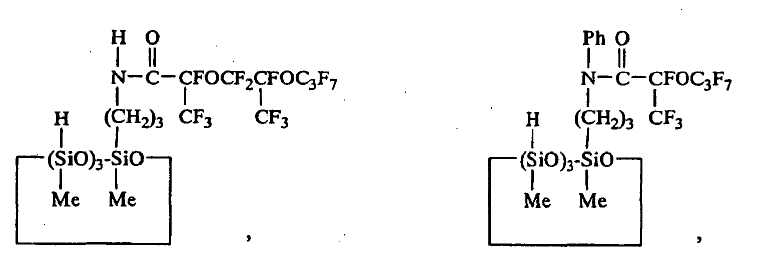

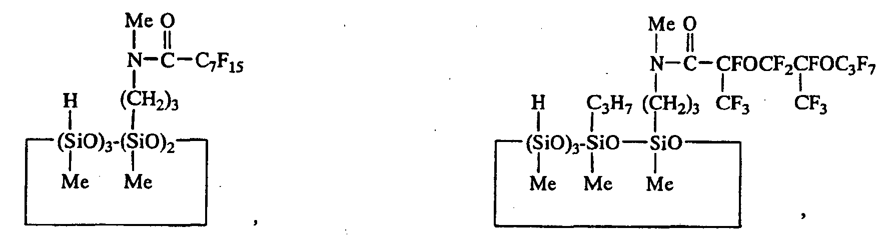

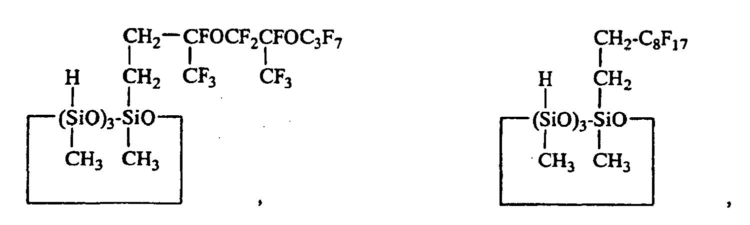

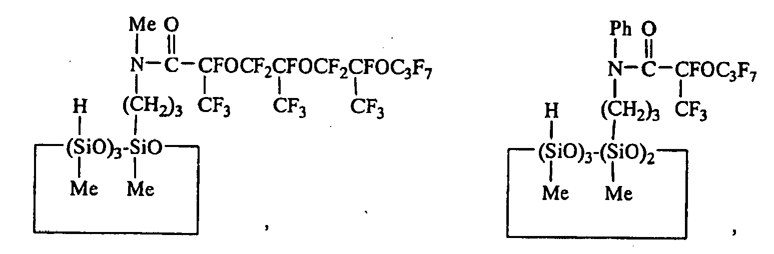

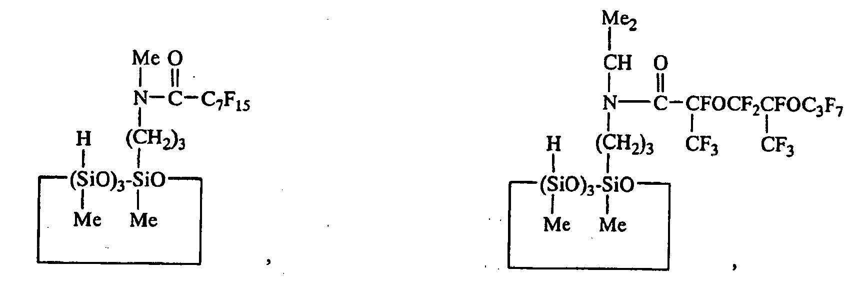

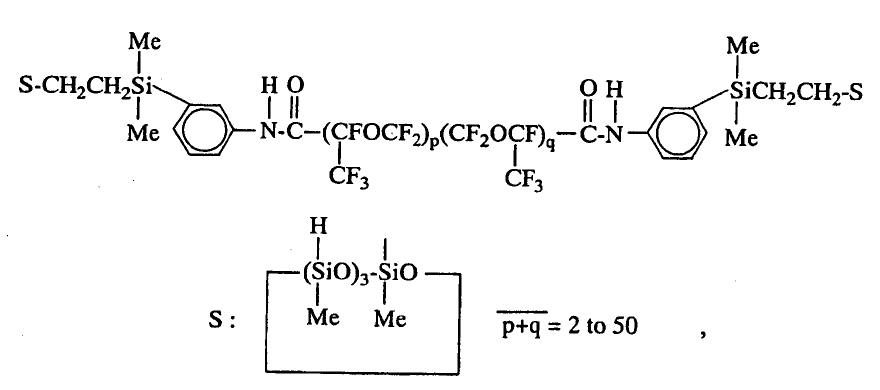

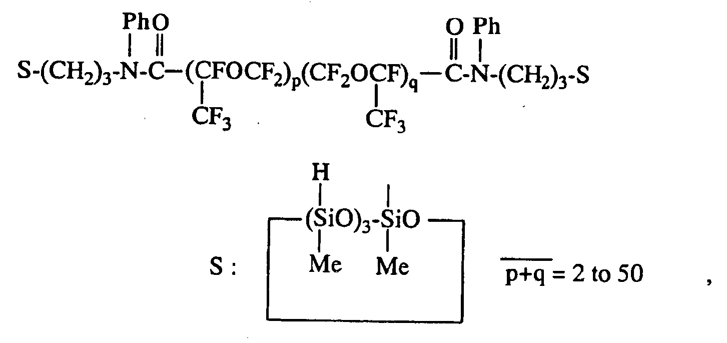

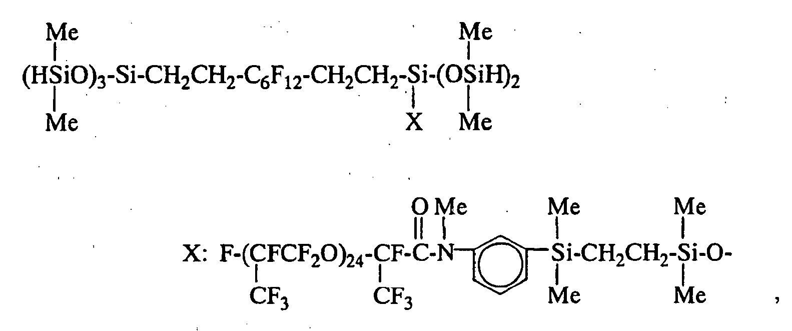

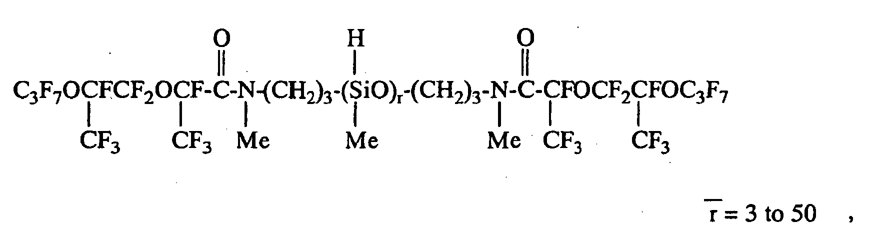

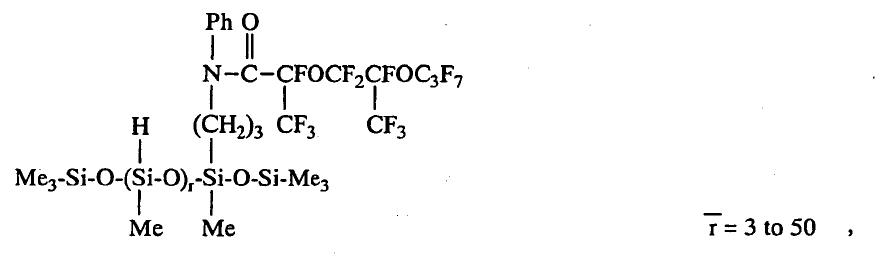

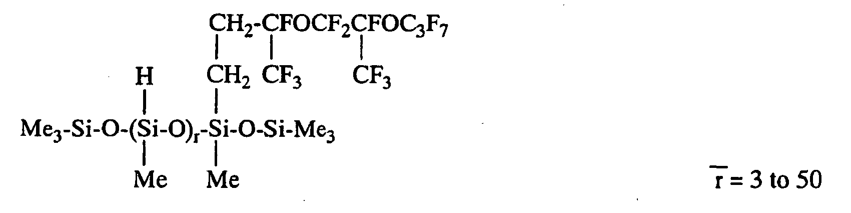

Preferably component (F) is present in an amount of 1 to 10 parts, more preferably 2 to 5 parts by weight per 100 parts by weight of component (E). Outside the range, a smaller amount of component (F) may induce insufficient cure reaction, resulting in a cured product which is flexible. A larger amount of component (F) may cause foaming.

Component (G) is a catalyst for addition reaction, which is preferably a platinum compound. The platinum compound is a catalyst for promoting addition reaction between aliphatic unsaturated monovalent hydrocarbon groups in component (E) and hydrosilyl groups in component (F). Advantageously it has superior catalysis for curing reaction around room temperature.

Examples of suitable platinum compounds include chloroplatinic acid, complexes of chloroplatinic acid reacted with alcohols, platinum-olefin complexes, platinum-vinylsiloxane complexes, platinum-ketone complexes, and platinum-aldehyde complexes. Inter alia, the reaction products of chloroplatinic acid with alcohols and platinum-vinylsiloxane complexes are preferred for superior catalysis.

Component (G) is compounded in such amounts as to provide 1 to 100 ppm, and preferably 2 to 50 ppm of platinum atom based on the weight of component (E). Less than 1 ppm of platinum may provide a low cure speed, resulting in under-cure. More than 100 ppm of platinum may lead to an extremely high cure speed that may hinder working after the components are combined together.

In the fluoroelastomer composition of the invention, any other components may be compounded for a particular purpose as long as the objects of the invention are not compromised. For example, cure retarders such as acetylene compounds, diallyl maleate, triallyl isocyanurate, nitrile compounds and organic peroxides may be compounded for prolonging the cure time of the composition at room temperature for facilitating working. Additionally, parting agents, pigments, plasticizers, flame retardants, thixotropic agents, fungicidal agents, mildew-proof agents or the like may be compounded, if desired.

The fluoroelastomer composition may be prepared by intimately mixing components (E) to (G) and optional components on a mixing apparatus such as a planetary mixer, Shinagawa mixer, universal mixer or kneader. Most often, the composition is prepared in a two pack system, one pack including component (F) and the other pack including component (G), which are separately stored and intimately mixed together immediately before use. Alternatively, all the components may be stored in a common container in the presence of a cure retarder.

The microcontact printing stamp is prepared by feeding the fluoroelastomer composition described above on a master with the negative of the desired fine pattern, curing the fluoroelastomer composition at a lower temperature for a shorter time than the desired conditions, feeding the silicone rubber composition described above thereon, curing the silicone rubber composition under the desired conditions to form an integral cured laminate of silicone rubber and fluoroelastomer, and removing the laminate having the desired fine pattern transferred by reversal. The integral cured laminate serves as a microcontact printing stamp. The fluoroelastomer composition may be cured at a relatively low temperature in the range from room temperature (25°C) to about 80°C, preferably at 40 to 80°C for 0.1 to 1 hour, and more preferably at 50 to 70°C for 0.2 to 0.5 hour. The silicone rubber composition is preferably cured at 120 to 200°C, and more preferably at 150 to 180°C for about 0.5 to 2 hours, and more preferably about 1 to 2 hours.

In the integral cured laminate of silicone rubber/fluoroelastomer, preferably the fluoroelastomer layer has a thickness of 0.5 µm to 500 µm, and the silicone rubber layer has a thickness of 100 µm to 3 mm, and more preferably the fluoroelastomer layer has a thickness of 1 µm to 100 µm, and the silicone rubber layer has a thickness of 500 µm to 2 mm. Usually the silicone layer is thicker than the fluoroelastomer.

The microcontact printing stamp or integral cured laminate preferably has a tensile strength of at least 1 MPa, more preferably at least 2 MPa, when a JIS #2 dumbbell sample is prepared from the integral cured laminate, and the tensile strength of the sample is measured by a tester Strograph (Toyo Seiki Seisakusho, Ltd.). A tensile strength in this range indicates a practically useful level of rubber hardness.

The swell resistance of the microcontact printing stamp or integral cured laminate may be evaluated by immersing a sample of the integral cured laminate in a solvent and measuring a percent change of volume of the sample before and after solvent immersion using an automated balance for specific gravity determination SGM-6 (Mettler-Toledo). A smaller percent volume change is preferred.

### EXAMPLE

Examples of the invention are given below by way of illustration and not by way of limitation. All parts are by weight. Me is methyl and Vi is vinyl. The term "end-capped" means that a siloxane is capped with the indicated groups at both ends of its molecular chain. The viscosity is a kinematic viscosity as measured at 25°C by an Ostwald viscometer.

A percent volume change and tensile strength were measured by the following methods.

### Volume change

A percent change of volume of a sample (microcontact printing stamp) before and after immersion in toluene was determined using an automated balance for specific gravity determination SGM-6 (Mettler-Toledo).

### Tensile strength

Measured according to JIS K6249.

### Example 1

### Silicone rubber composition

A silicone compound #1 was prepared by mixing the following components on a planetary mixer at room temperature for one hour: (A) 100 parts of a linear dimethylpolysiloxane composed of intermediate units (backbone recurring units) of dimethylsiloxane units, end-capped with dimethylvinylsiloxy groups, and having a viscosity of 5,000 mm²/s, and (D) 40 parts of a vinyl-containing methylpolysiloxane resin consisting of Vi(Me)₂SiO_{1/2} units and SiO_{4/2} units in a molar ratio of 0.8:1 and having a viscosity of 5,000 mm²/s.

A curing agent #1 was prepared by intimately mixing the following components: (A) 100 parts of a dimethylvinylsiloxy-endcapped dimethylpolysiloxane (vinyl content 0.2 wt%) having a viscosity of 1,000 mm²/s, (B) 3 parts of a trimethylsiloxy-endcapped methylhydrogenpolysiloxane (SiH content 1.5 wt%) having a viscosity of 30 mm²/s, and (C) 0.3 part (providing 5 ppm of platinum metal based on the final composition) of a microparticulate catalyst obtained by dispersing a complex of chloroplatinic acid with vinylsiloxane in a thermoplastic silicone resin with a softening point of 80-90°C, followed by atomization.

### Fluoroelastomer composition

A fluoroelastomer compound #11 was (E) 100 parts of a dimethylvinylsiloxy-endcapped linear perfluoropolyether compound of the following formula, containing recurring units: -CₐF₂ₐO- (wherein a is an integer of 1 to 6) in the backbone and having a viscosity of 2,300 mm²/s.

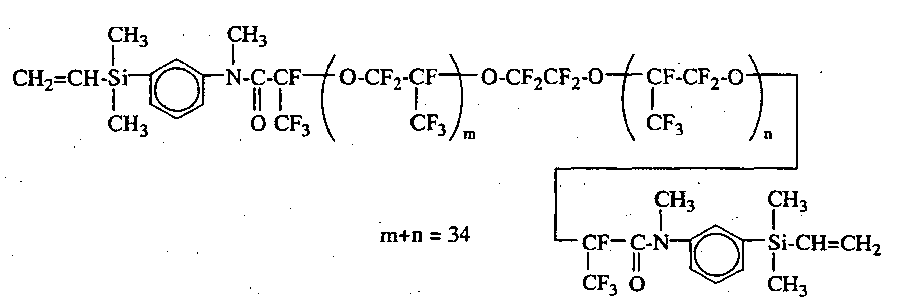

A curing agent #11 was prepared by intimately mixing the following components: (F) 46 parts (providing a molar ratio of silicon-bonded hydrogen in (F) to silicon-bonded vinyl in (E), Si-H/Si-Vi = 1.05) of a compound of the following formula, having a viscosity of 3,000 mm²/s, and (G) 0.3 part (providing 5 ppm of platinum metal based on the final composition) of a microparticulate catalyst obtained by dispersing a complex of chloroplatinic acid with vinylsiloxane in a thermoplastic silicone resin with a softening point of 80-90°C, followed by atomization.

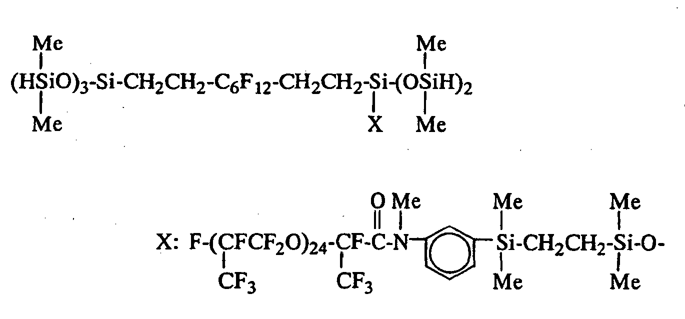

### Integral laminate

Fluoroelastomer compound #11 and curing agent #11 were mixed in a weight ratio of 100:10 to form a fluoroelastomer composition. This fluoroelastomer composition (1 g) was placed on a silicon master having a negative fine-size pattern, and cured at 70°C for 0.5 hour. Silicone compound #1 and curing agent #1 were mixed in a weight ratio of 100:10 to form a silicone rubber composition. This silicone rubber composition (50 g) was placed on the fluoroelastomer layer and cured at 150°C for one hour. There was obtained an integral cured laminate consisting of the silicone rubber layer of 1.5 mm thick and the fluoroelastomer layer of 0.5 mm thick. The tensile strength of the integral cured laminate was measured, with the result shown in Table 1.

### Comparative Example 1

Silicone compound #1 and curing agent #1 were mixed in a weight ratio of 100:10 to form a silicone rubber composition, which was sheeted and cured at 150°C for one hour into a sheet of 2 mm thick. The tensile strength of this sheet was measured, with the result shown in Table 1.

### Comparative Example 2

Fluoroelastomer compound #11 and curing agent #11 were mixed in a weight ratio of 100:10 to form a fluoroelastomer composition, which was sheeted and cured at 150°C for one hour into a sheet of 2 mm thick. The tensile strength of this sheet was measured, with the result shown in Table 1.

**Table 1**

| | Example | Comparative Example | |
|---|---|---|---|
| | 1 | 1 | 2 |
| Tensile strength, MPa | 8.5 | 8.5 | 0.3 |

A toluene immersion test was carried out on both the silicone rubber sheet of 2 mm thick prepared by mixing silicone compound #1 and curing agent #1 in a weight ratio of 100:10 and curing at 150°C for one hour and the fluoroelastomer sheet of 2 mm thick prepared by mixing fluoroelastomer compound #11 and curing agent #11 in a weight ratio of 100:10 and curing at 150°C for one hour. A percent change of volume of the sheet before and after toluene immersion for 2 hours was determined, with the results shown in Table 2.

**Table 2**

| | Silicone rubber | Fluoroelastomer |
|---|---|---|
| Volume change, % | 186 | 0.05 |

## Claims

1. A microcontact printing stamp comprising, in laminate structure, a cured layer of an addition reaction cure silicone rubber composition overlaid with a cured layer of a fluoroelastomer composition which is a curable perfluoropolyether composition comprising (E) a linear perfluoropolyether compound containing at least two aliphatic unsaturated monovalent hydrocarbon groups in a molecule, having a perfluoropolyether structure containing recurring units: -CaF₂ₐO- wherein a is an integer of 1 to 6 in the backbone, and having a number average molecular weight of 5,000 to 100,000 and (F) a compound having at least two silicon-bonded hydrogen atoms in a molecule.

2. The microcontact printing stamp of claim 1 wherein the addition reaction cure silicone rubber composition comprises
(A) an organopolysiloxane containing at least two aliphatic unsaturated monovalent hydrocarbon groups in a molecule,
(B) an organohydrogenpolysiloxane containing at least two silicon-bonded hydrogen atoms in a molecule,
(C) an addition reaction catalyst, and
(D) a reinforcing resin.

3. The microcontact printing stamp of claim 2 wherein the addition reaction cure silicone rubber composition comprises
100 parts by weight of component (A),
component (B) in a sufficient amount to give 0.5 to 5 silicon-bonded hydrogen atoms per aliphatic unsaturated monovalent hydrocarbon group in components (A) and (D),
component (C) in a sufficient amount to give 1 to 100 ppm of platinum atom based on the weight of component (A), and
5 to 100 parts by weight of component (D).

4. The microcontact printing stamp of claim 2 or 3 wherein component (A) is a linear diorganopolysiloxane, and component (D) is a reinforcing resin containing alkenyl groups.

5. The microcontact printing stamp of any one of claims 1 to 4 wherein the perfluoropolyether composition comprises 100 parts by weight of component (E) and 1 to 10 parts by weight of component (F).

6. The microcontact printing stamp of any one of the preceding claims in which said silicone rubber layer has a thickness of 100 µm to 3 mm, and said fluoroelastomer layer has a thickness of 0.5 µm to 500 µm.

7. A method of making a microcontact printing stamp of any one of claims 1 to 6 in which a layer of the fluoroelastomer composition is applied to a master having a negative of a desired pattern and cured, and the silicone rubber composition is applied to the layer of fluoroelastomer composition and cured.

8. A method of claim 7 in which the fluoroelastomer composition layer is part-cured when the silicone rubber composition is applied.

9. A method of microcontact printing using a microcontact stamp according to any one of claims 1 to 6.

## Patentansprüche

1. Mikrokontakt-Druckstempel, der in einer Laminatstruktur eine gehärtete Schicht aus einer mittels Additionsreaktion härtbaren Siliconkautschukzusammensetzung umfasst, die mit einer gehärteten Schicht aus einer Fluorelastomerzusammensetzung überlagert ist, die eine härtbare Perfluorpolyetherzusammensetzung ist, die Folgendes umfasst: (E) eine unverzweigte Perfluorpolyetherverbindung, die zumindest zwei aliphatische, ungesättigte, einwertige Kohlenwasserstoffgruppen pro Molekül enthält, mit einer Perfluorpolyetherstruktur, die Grundeinheiten -CₐF₂ₐO-, worin a eine ganze Zahl von 1 bis 6 ist, im Rückgrat enthält und mit einem zahlenmittleren Molekulargewicht von 5.000 bis 100.000, sowie (F) eine Verbindung mit zumindest zwei an Silicium gebundenen Wasserstoffatomen im Molekül.

2. Mikrokontakt-Druckstempel nach Anspruch 1, wobei die mittels Additionsreaktion härtbare Siliconkautschukzusammensetzung Folgendes umfasst:
(A) ein Organopolysiloxan mit zumindest zwei aliphatischen ungesättigten einwertigen Kohlenwasserstoffgruppen pro Molekül,
(B) ein Oganohydrogenpolysiloxan mit zumindest zwei an Silicium gebundenen Wasserstoffatomen im Molekül,
(C) einen Additionsreaktionskatalysator und
(D) ein Verstärkungsharz.

3. Mikrokontakt-Druckstempel nach Anspruch 2, wobei die mittels Additionsreaktion härtbare Siliconkautschukzusammensetzung Folgendes umfasst:
100 Gewichtsteile von Komponente (A),
Komponente (B) in einer Menge, die ausreicht, um 0,5 bis 5 an Silicium gebundene Wasserstoffatome pro aliphatischer ungesättigter einwertiger Kohlenwasserstoffgruppe in den Komponenten (A) und (D) zu ergeben,
Komponente (C) in einer Menge, die ausreicht, um 1 bis 100 ppm Platinatome, bezogen auf das Gewicht der Komponente (A), zu ergeben und
5 bis 100 Gewichtsteile von Komponente (D).

4. Mikrokontakt-Druckstempel nach Anspruch 2 oder 3, wobei Komponente (A) ein unverzweigtes Diorganopolysiloxan ist und Komponente (D) ein Verstärkungsharz ist, das Alkenylgruppen enthält.

5. Mikrokontakt-Druckstempel nach einem der Ansprüche 1 bis 4, wobei die Perfluorpolyetherzusammensetzung 100 Gewichtsteile von Komponente (E) und 1 bis 10 Gewichtsteile von Komponente (F) enthält.

6. Mikrokontakt-Druckstempel nach einem der vorangegangenen Ansprüche, wobei die Siliconkautschukschicht eine Dicke von 100 µm bis 2 mm aufweist und die Fluorelastomerschicht eine Dicke von 0,5 µm bis 500 µm aufweist.

7. Verfahren zur Herstellung eines Mikrokontakt-Druckstempels nach einem der Ansprüche 1 bis 6, wobei die Schicht aus der Fluorelastomerzusammensetzung auf eine Matrize mit einem Negativ eines gewünschten Musters aufgebracht und gehärtet wird und die Siliconkautschukschicht auf die Schicht aus der Fluorelastomerzusammensetzung aufgebracht und gehärtet wird.

8. Verfahren nach Anspruch 7, wobei die Fluorelastomerzusammensetzungsschicht teilweise gehärtet wird, wenn die Siliconkautschukzusammensetzung aufgebracht wird.

9. Verfahren zum Mikrokontaktdrucken unter Verwendung eines Mikrokontakt-Druckstempels nach einem der Ansprüche 1 bis 6.

## Revendications

1. Tampon d'impression par microcontact comprenant, en structure stratifiée, une couche durcie d'une composition de caoutchouc siliconé durcissant par une réaction d'addition recouverte d'une couche durcie d'une composition d'élastomère fluoré qui est une composition de perfluoropolyéther durcissable comprenant (E) un composé perfluoropolyéther linéaire contenant au moins deux groupes hydrocarbonés monovalents insaturés aliphatiques par molécule, ayant une structure de perfluoropolyéther contenant des motifs récurrents -C₂F₂ₐO- dans lesquels a est un entier de 1 à 6 dans la charpente, et ayant une masse moléculaire moyenne en nombre de 5 000 à 100 000 et (F) un composé ayant au moins deux atomes d'hydrogène liés au silicium par molécule.

2. Tampon d'impression par microcontact selon la revendication 1, dans lequel la composition de caoutchouc siliconé durcissant par une réaction d'addition comprend
(A) un organopolysiloxane contenant au moins deux groupes hydrocarbonés monovalents insaturés aliphatiques par molécule,
(B) un organohydrogénopolysiloxane contenant au moins deux atomes d'hydrogène liés au silicium par molécule,
(C) un catalyseur de réaction d'addition, et
(D) une résine de renforcement.

3. Tampon d'impression par microcontact selon la revendication 2, dans lequel la composition de caoutchouc siliconé durcissant par une réaction d'addition comprend
100 parties en poids de composant (A),
le composant (B) en une quantité suffisante pour qu'il y ait 0,5 à 5 atomes d'hydrogène liés au silicium par groupe hydrocarboné monovalent insaturé aliphatique dans les composants (A) et (D),
le composant (C) en une quantité suffisante pour qu'il y ait 1 à 100 ppm d'atomes de platine par rapport au poids du composant (A), et
5 à 100 parties en poids de composant (D).

4. Tampon d'impression par microcontact selon la revendication 2 ou 3, dans lequel le composant (A) est un diorganopolysiloxane linéaire, et le composant (D) est une résine de renforcement contenant des groupes alcényle.

5. Tampon d'impression par microcontact selon l'une quelconque des revendications 1 à 4, dans lequel la composition de perfluoropolyéther comprend 100 parties en poids de composant (E) et 1 à 10 parties en poids de composant (F).

6. Tampon d'impression par microcontact selon l'une quelconque des revendications précédentes, dans lequel ladite couche de caoutchouc siliconé a une épaisseur de 100 µm à 3 mm, et ladite couche d'élastomère fluoré a une épaisseur de 0,5 µm à 500 µm.

7. Procédé pour préparer un tampon d'impression par microcontact selon l'une quelconque des revendications 1 à 6, dans lequel une couche de la composition d'élastomère fluoré est appliquée sur un gabarit ayant un négatif d'un motif souhaité et durcie, et la composition de caoutchouc siliconé est appliquée sur la couche de la composition d'élastomère fluoré et durcie.

8. Procédé selon la revendication 7, dans lequel la couche de composition d'élastomère fluoré est durcie en partie quand la composition de caoutchouc siliconé est appliquée.

9. Procédé d'impression par microcontact utilisant un tampon de microcontact selon l'une quelconque des revendications 1 à 6.
